(19) **Europäisches Patentamt / European Patent Office / Office européen des brevets**

(11) **EP 2 365 320 B1**

(12) **EUROPEAN PATENT SPECIFICATION**

(45) Date of publication and mention
of the grant of the patent:
**29.08.2018 Bulletin 2018/35**

(21) Application number: **11153152.1**

(22) Date of filing: **03.02.2011**

(51) Int Cl.:
*G01N 23/18* (2018.01)     *H01L 21/66* (2006.01)
*G01N 23/04* (2018.01)     *H05K 13/08* (2006.01)

(54) **X-ray inspection apparatus, x-ray inspection method and x-ray inspection program**

Röntgenuntersuchungsvorrichtung, Röntgenuntersuchungsverfahren und Röntgenuntersuchungsprogramm

Appareil, procédé et programme d'inspection à rayons X

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **12.03.2010 JP 2010055319**

(43) Date of publication of application:
**14.09.2011 Bulletin 2011/37**

(73) Proprietor: **Omron Corporation**
**Kyoto-shi, Kyoto 600-8530 (JP)**

(72) Inventors:
• **Murakami, Kiyoshi**
**Kyoto-shi, Kyoto 600-8530 (JP)**
• **Kasahara, Hironori**
**Kyoto-shi, Kyoto 600-8530 (JP)**

(74) Representative: **Kilian Kilian & Partner**
**Aidenbachstraße 54**
**81379 München (DE)**

(56) References cited:
**US-A1- 2006 002 510**     **US-B1- 6 272 204**

• **Stefan Becker ET AL: "CAD-Based, High-Resolution AXI Of Solder Joints", OnBoard Technology, 30 June 2008 (2008-06-30), pages 14-16, XP055099113, Retrieved from the Internet: URL:http://www.onboard-technology.com/pdf_ giugno2008/060802.pdf [retrieved on 2014-01-29]**
• **ROOKS S M ET AL: "DEVELOPMENT OF AN INSPECTION PROCESS FOR BALL-GRID-ARRAY TECHNOLOGYUSING SCANNED-BEAM X-RAY LAMINOGRAPHY", IEEE TRANSACTIONS ON COMPONENTS, PACKAGING ANDMANUFACTURING TECHNOLOGY: PART A, IEEE SERVICE CENTER, PISCATAWAY, NJ, US, vol. 18, no. 4, 1 December 1995 (1995-12-01), pages 851-860, XP000542890, ISSN: 1070-9886, DOI: 10.1109/95.477473**

## Description

BACKGROUND OF THE INVENTION

1. TECHNICAL FIELD

The present invention relates to an X-ray inspection apparatus, an X-ray inspection method and a computer readable medium storing a computer program which, when executed on a computer, executes the steps of said X-ray inspection method. Particularly, the invention relates to an X-ray inspection apparatus, an X-ray inspection method and a computer program which are used to inspect a connection between a printed board and a circuit component.

2. RELATED ART

Conventionally, an X-ray CT (Computed Tomography) is frequently used to inspect whether the soldering state is nondefective in a printed board (hereinafter also simply referred to as "board") on which a mounting component is soldered. In the X-ray CT, an object is imaged with the X-ray from various directions to acquire a plurality of perspective images indicating a distribution of a degree of X-ray absorption (attenuation). Further, reconfiguration processing is performed based on the plurality of perspective images to acquire two-dimensional data or three-dimensional data of an X-ray absorption coefficient distribution of the inspection target. An image in which the absorption coefficient distribution of a two-dimensional space is obtained is particularly called a cross-sectional image.

For example, Japanese Unexamined Patent Publication No.2006-292465 discloses a method for extracting a wiring pattern on the board to specify an inspection position based on the wiring pattern in a technology, in which the board is imaged with the X-ray from a horizontal direction to acquire a cross-sectional image of the inspection target and a nondefective determination is made by comparing a diameter of the inspection target acquired from the cross-sectional image and a threshold.

However, in the method disclosed in Japanese Unexamined Patent Publication No. 2006-292465, there is a problem in that inspection accuracy is degraded unless the cross-sectional image used in the nondefective determination is properly specified. Particularly, it is necessary to properly specify the inspection position in the case where the inspection target is a small portion such as a solder ball of a Ball Grid Array (hereinafter abbreviated to as BGA).

In the method of Japanese Unexamined Patent Publication No. 2006-292465, it is necessary to specify a wiring pattern region with respect to a surface at a predetermined height from a position of the wiring pattern on the board, which results in a possibility for generation of a human error such as a false setting and a variation of the inspection position by a person who performs the setting.

Additionally, in the method of Japanese Unexamined Patent Publication No. 2006-292465, a boundary between the solder and the solder ball cannot be specified based only on the height from the wiring pattern, which results in a problem in that the inspection position cannot properly be specified.

On the other hand, because the inspection is performed in a production process, it is necessary to not only improve inspection accuracy but also enhance an inspection rate in order not to obstruct production efficiency. Further relevant prior art is disclosed in the articles "Development of an inspection process for ball-grid-array technology using scanned-beam X-ray laminography" by Rooks S M et al, published in IEEE transactions on components, packaging and manufacturing technology: part A, vol. 18, 1 December 1995, pages 851-860 and "CAD-based, high-resolution AXI of Solder joints" by Becker S. et al., published in OnBoard Technology, June 2008, pages 14-16.

SUMMARY

The present invention has been devised to solve the problems described above, and an object thereof is to provide an X-ray inspection apparatus, an X-ray inspection method and a computer program, which can perform the inspection at high rate with high accuracy. These objects are solved by the X-ray inspection apparatus according to claim 1, the X-ray inspection method according to claim 10 and a computer readable medium storing a computer program according to claim 11, respectively. Further preferred embodiments of the invention are defined by the dependent claims.

According to the invention, the connection state of the component can be inspected at high rate with high accuracy.

BRIEF DESCRIPTION OF THE DRAWINGS

Fig. 1 is a schematic block diagram of an X-ray inspection apparatus according to an embodiment of the invention;
Fig. 2 is a view for explaining a configuration of the X-ray inspection apparatus of the embodiment;
Fig. 3 is a side view illustrating an inspection target and a periphery thereof:
Fig. 4 is a flowchart illustrating a flow of X-ray inspection of the embodiment;
Fig. 5 is a flowchart illustrating a flow of a teaching operation;
Fig. 6A is a flowchart illustrating a flow of an operation to set an inspection window, and Fig. 6B illustrates a defined coordinate system;
Fig. 7 is a view illustrating a specific example of the inspection window;

Fig. 8 is a flowchart illustrating a flow of a test operation during the teaching operation;

Fig. 9 is a view explaining a connection of a BGA to a board;

Fig. 10 is a flowchart illustrating a flow of an inspection operation;

Fig. 11 is a view illustrating an output example of an inspection result;

Fig. 12 is a view illustrating a configuration example of a system when the system connects the BGA to the board; and

Fig. 13 is a view explaining an index expressing a phenomenon in which a solder ball and cream solder are not integrated due to incomplete melting.

DETAILED DESCRIPTION

Hereinafter, preferred embodiments of the present invention will be described with reference to the drawings. In the following description, the identical component and constituent are designated by the identical numerals, and the names and functions are identical thereto.

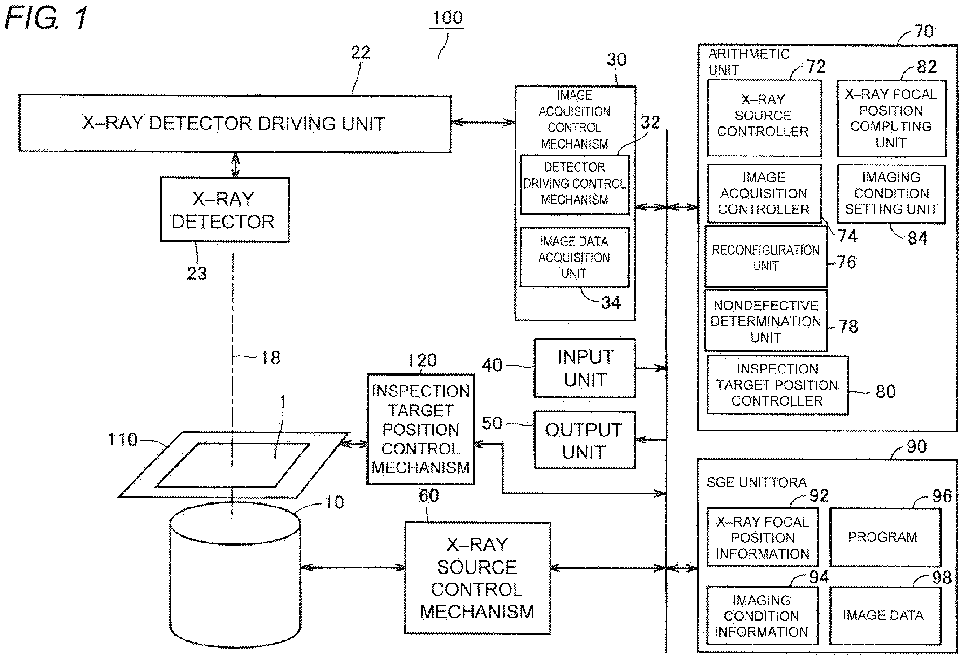

A configuration of an X-ray inspection apparatus 100 according to an embodiment of the invention will be described with reference to Fig. 1. Referring to Fig. 1, the X-ray inspection apparatus 100 includes an X-ray source 10 that emits an X-ray 18, an X-ray detector 23, an image acquisition control mechanism 30, and an inspection target driving mechanism 110 that moves a position of an inspection target 1. The X-ray inspection apparatus 100 also includes an input unit 40, an output unit 50, an X-ray source control mechanism 60 that controls an output of an electron beam, an inspection target position control mechanism 120, an arithmetic unit 70, and a storage unit 90.

The inspection target 1 is placed between the X-ray source 10 and the X-ray detector 23. In the present embodiment, it is assumed that the inspection target 1 is a circuit board on which a component is mounted. In Fig. 1, the X-ray source 10, the inspection target 1, and the X-ray detector 23 are set up from the bottom up. Alternatively, from the viewpoint of maintenance of the X-ray source, the X-ray detector 23, the inspection target 1, and the X-ray source 10 may be set up from the bottom up.

The X-ray source 10 is controlled by the X-ray source control mechanism 60 to irradiate the inspection target 1 with the X-ray 18. In the present embodiment, the inspection target 1 is a substrate on which a circuit board is mounted.

The inspection target 1 is moved by the inspection target driving mechanism 110. A specific configuration of the inspection target driving mechanism 110 is described later. The inspection target position control mechanism 120 controls an operation of the inspection target driving mechanism 110 based on an instruction from the arithmetic unit 70.

The X-ray detector 23 is a two-dimensional X-ray detector that detects the X-ray, emitted from the X-ray source 10 and transmitted through the inspection target 1, to form an image. An I. I. (Image Intensifier) tube or an FPD (Flat Panel Detector) can be used as the X-ray detector 23. From the viewpoint of an installation space, desirably the FPD is used as the X-ray detector 23.

The image acquisition control mechanism 30 includes a detector driving control mechanism 32 and an image data acquisition unit 34. The detector driving control mechanism 32 controls an X-ray detector driving unit 22 to move the X-ray detector 23 based on the instruction from the arithmetic unit 70. The image data acquisition unit 34 acquires image data of the X-ray detector 23, the image data being assigned from the arithmetic unit 70.

The input unit 40 is a manipulation input device that receives an instruction input and the like from a user. The output unit 50 is a device that outputs a measurement result to the outside. In the present embodiment, the output unit 50 is a display on which an X-ray image formed by the arithmetic unit 70 is displayed.

The user can perform various inputs through the input unit 40, and various arithmetic results acquired through processing of the arithmetic unit 70 are displayed on the output unit 50. The image displayed on the output unit 50 may be output for a visual nondefective determination made by the user or as a nondefective determination result of a nondefective determination unit 78.

The X-ray source control mechanism 60 receives an assignment of X-ray energy (tube voltage and tube current) from the arithmetic unit 70. The assigned X-ray energy depends on the inspection target.

The arithmetic unit 70 executes a program 96 stored in the storage unit 90 to control each unit and performs predetermined arithmetic processing. The arithmetic unit 70 includes an X-ray source controller 72, an image acquisition controller 74, a reconfiguration unit 76, the nondefective determination unit 78, an inspection target position controller 80, an X-ray focal position computing unit 82, and an imaging condition setting unit 84.

The X-ray source controller 72 obtains an X-ray focal position and the X-ray energy to transmits an instruction to the X-ray source control mechanism 60.

The image acquisition controller 74 transmits an instruction to the image acquisition control mechanism 30 such that the X-ray detector 23 acquires the image. The image acquisition controller 74 acquires image data from the image acquisition control mechanism 30.

The reconfiguration unit 76 reconfigures three-dimensional data from the plurality of pieces of image data acquired by the image acquisition controller 74.

Based on information from the input unit 40, the nondefective determination unit 78 defines a range of a height from a board surface that is of an inspection range and determines whether a connection of the inspection target is nondefective based on a cross-sectional image in the range. Because an algorithm used to make the nondefective determination or input information for the algorithm depends on the kind of the inspection target, the nondefective determination unit 78 acquires the algorithm or the input information from imaging condition information 94 described below.

The inspection target position controller 80 controls the inspection target driving mechanism 110 through the inspection target position control mechanism 120.

The X-ray focal position computing unit 82 computes the X-ray focal position or an irradiation angle of an inspection area when inspecting the inspection area where the inspection target 1 exists.

The X-ray imaging condition setting unit 84 sets conditions (such as a voltage applied to the X-ray source 10 and an imaging time) according to the inspection target 1 when the X-ray source 10 emits the X-ray.

The storage unit 90 includes X-ray focal position information 92, the imaging condition information 94, the program 96 that used to implement each function performed by the arithmetic unit 70, and image data 98 that is imaged by the X-ray detector 23. The X-ray focal position information 92 includes the X-ray focal position computed by the X-ray imaging condition setting unit 84. The imaging condition information 94 includes the imaging condition set by the X-ray imaging condition setting unit 84 and the information on the algorithm used to make the nondefective determination.

Any storage device in which the data is stored may be used as the storage unit 90. For example, the storage unit 90 includes a storage device such as a RAM (Random Access Memory), an EEPROM (Electrically Erasable and Programmable Read-Only Memory), and a HDD (Hard Disc Drive).

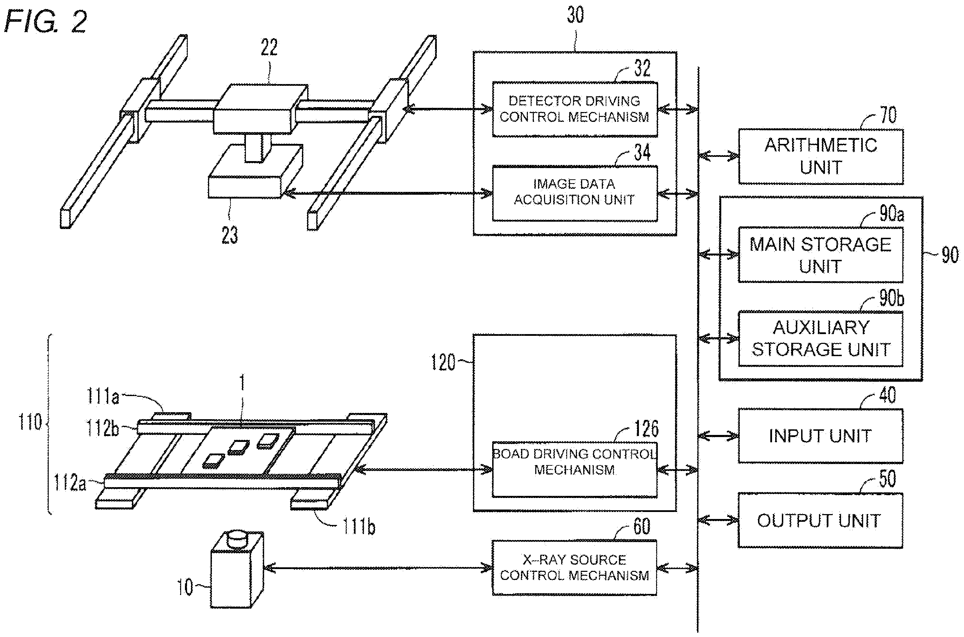

A specific configuration of the X-ray inspection apparatus 100 will be described below with reference to Fig. 2. In Fig. 2, a component identical to that of Fig. 1 is designated by the identical numeral. Fig. 2 illustrates only components that are necessary for the descriptions and directly relate to the control of the X-ray focal position, the control of the X-ray detector position, and the control of the inspection target position in the components of Fig. 1.

The X-ray source 10 is a close type X-ray source that is disposed in an upper portion or a lower portion of the X-ray inspection apparatus 100. In the present embodiment, the X-ray source 10 is a fixed-focus type X-ray source in which a position (X-ray focal position) where the X-ray is emitted is fixed. The X-ray source 10 emits the X-ray in response to a command from the arithmetic unit 70 through the X-ray source control mechanism 60. Either a transmission type target or a reflection type target may be used in X-ray source 10. The X-ray source 10 is attached to a running unit (not illustrated) to be able to move in a vertical direction.

The X-ray detector 23 is disposed opposite the X-ray source 10 such that the inspection target 1 (board) is sandwiched therebetween. The X-ray detector 23 forms an image with the X-ray emitted from the X-ray source 10. The X-ray detector 23 is attached to the X-ray detector driving unit 22. The X-ray detector driving unit 22 is a three-dimensional stage that can move the X-ray detector 23 in the horizontal direction and the vertical direction.

The inspection target driving mechanism 110 is disposed between the X-ray source 10 and the X-ray detector 23. The inspection target driving mechanism 110 includes stages 111a and 111b and board rails 112a and 112b attached to the stages 111a and 111b. The stages 111a and 111b can horizontally move the inspection target 1. The board is fixed such that the inspection target 1 is vertically sandwiched between each two of the board rails 112a and 112b.

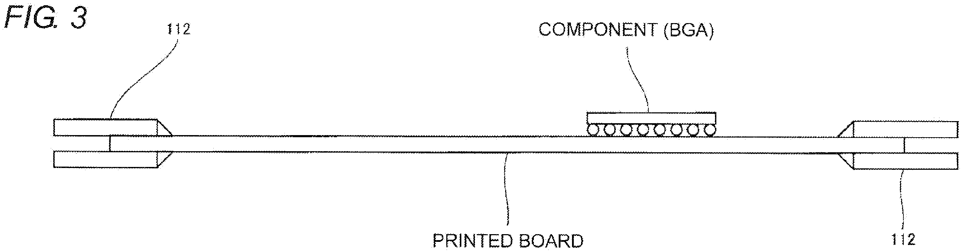

A disposition of the inspection target 1 will be described in detail with reference to Fig. 3. Referring to Fig. 3, the printed board included in the inspection target 1 is fixed by the pair of rails 112. In each rail 112, a left end or a right end of the inspection target 1 is vertically sandwiched to fix the printed board.

The rails 112 can move in the horizontal (X-Y) direction and the vertical (Z) direction in response to the command from the inspection target position controller 80. In the present embodiment, it is assumed that the inspection target driving mechanism 110 conveys the inspection target 1 in substantially parallel with a horizontal plane, that is, along a conveying plane whose normal direction is substantially the Z-direction. As used herein, "the normal direction is substantially the Z-direction" means that the conveying plane may be inclined from the horizontal plane within an uninterrupted range (for example, 0 to 5 degrees) in the inspection.

A general Central Processing Unit (CPU) can be used as the arithmetic unit 70. The storage unit 90 includes a main storage unit 90a and an auxiliary storage unit 90b. For example, a memory can be used as the main storage unit 90a, and an HDD (Hard Disk Drive) can be used as the auxiliary storage unit 90b. That is, a general computer can be used as the arithmetic unit 70 and the storage unit 90.

Therefore, the X-ray inspection apparatus 100 can change a ratio (magnification) of a source-board distance and a source-detector distance. As a result, the X-ray inspection apparatus 100 can change a size (accordingly, resolution) of the inspection target 1 imaged by the X-ray detector 23.

In the X-ray inspection apparatus 100, the board and the X-ray detector 23 can be moved such that the board can be imaged from various directions. In the present embodiment, based on the imaging results from various directions, the three-dimensional data of the inspection target 1 is produced using a three-dimensional data producing technique called CT (Computed Tomography).

In the present embodiment, the X-ray inspection apparatus 100 is used in an in-line inspection. The inspection target driving mechanism 110 also includes a mechanism that carries in and takes out the board for the purpose of the in-line inspection. The mechanism that carries in and takes out the board is not illustrated in Fig. 2. Generally a belt conveyer disposed on the board rails is used as the mechanism that carries in and takes out the board. Alternatively, a rod called a pusher may be used as the mechanism that carries in and takes out the board. The board can be slid on the rails by the pusher to move the board.

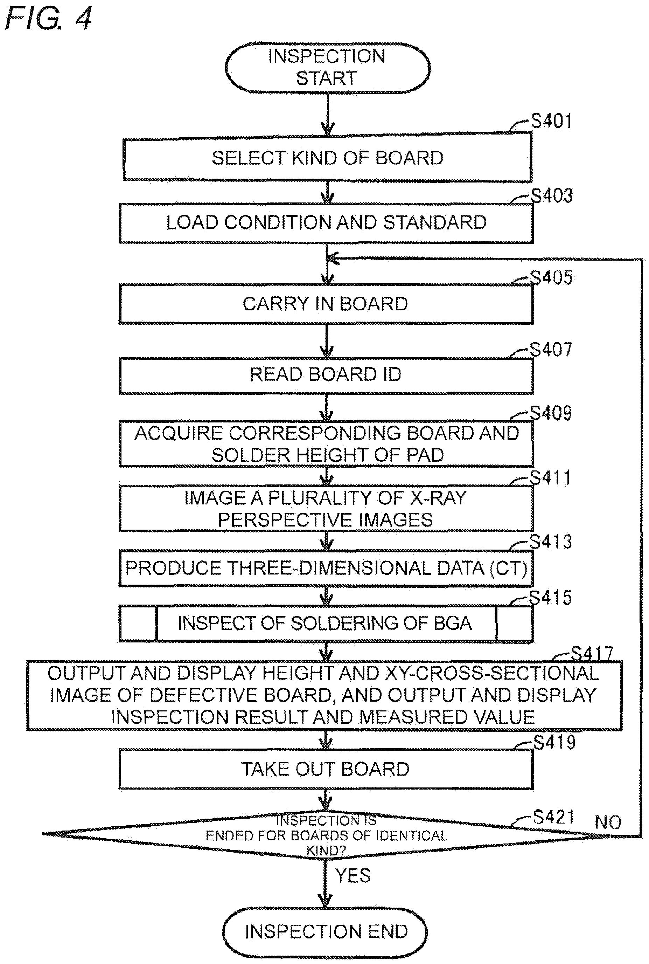

A whole flow of the X-ray inspection of the present embodiment will be described with reference to Fig. 4. The arithmetic unit 70 reads and executes the program 96 stored in the storage unit 90 and controls each unit of Fig, 1, thereby performing the operation illustrated in Fig. 4.

Referring to Fig. 4, when the processing is started, the input unit 40 of the X-ray inspection apparatus 100 receives the selection of the kind of the board that is of the inspection target 1 in Step S401. An inspection condition and a standard, set by a teaching operation, are previously stored every kind of the board that is of the inspection target 1 in a predetermined space of the storage unit 90. In Step S403, the nondefective determination unit 78 reads the inspection condition and the standard from the predetermined space of the storage unit 90 according to the kind of the board received in Step S401.

In Step S405, the inspection target driving mechanism 110 carries in the board to a defined position in the X-ray inspection apparatus 100. Preferably the defined position is usually set to the center of the X-ray inspection apparatus 100, that is, the center of X-ray irradiation range. However, the defined position may be set anywhere as long as the X-ray detector 23 can image the X-ray perspective image of the board.

Preferably information (ID) unique to the board of information (ID) indicating the kind of the board is printed on the board that is of the inspection target 1. The X-ray inspection apparatus 100 includes a read device such as an optical sensor (not illustrated in Fig. 1 and Fig. 2), and the unique information on the board conveyed in Step S405 is read in Step S407. In Step S407, instead of the optical read, the unique information may be received from the input unit 40, or physical read may be performed.

In Step S409, the nondefective determination unit 78 reads a solder thickness from a surface of the board according to the kind of the board that is of the inspection target 1 and sets the inspection range based on the solder thickness. The solder thickness is previously stored in the storage unit 90 by the teaching operation while correlated with the kind of the board.

At this point, it is assumed that the inspection target 1 is a board that is physically and electrically connected to the BGA (Ball Grid Array), and it is assumed that X-ray inspection apparatus 100 inspects a soldering state of the BGA board. Cream solder is printed with a squeeze of a cream solder printer using a mask called metal mask, thereby applying the solder to the board. In the metallic plate having a thickness of about 100 to about 300 micrometers, holes are made according to a pattern (position in which BGA should be mounted) of the board. In Step S409, a thickness (hereinafter also referred to as a mask thickness) of the metal mask is read as an example of the cream solder thickness. The detailed description is made later.

In Step S411, the X-ray inspection apparatus 100 images one reconfiguration region (hereinafter referred to as a visual field) from a plurality of directions in the inspection target 1. In the present embodiment, the X-ray inspection apparatus 100 images the visual field from a plurality of directions while moving the board and the X-ray detector 23 such that the board and the X-ray detector 23 draw a circular orbit in the horizontal direction. During the imaging, the positions of the board and X-ray detector 23 are decided by a radiation angle $\theta R$, a source-board distance (FOD), and a source-detector distance (FID). The board and the X-ray detector 23 are disposed such that the center of the visual field is imaged in the center of the X-ray detector 23. The orbits of the board and X-ray detector 23 are not limited to the circle, but the board and the X-ray detector 23 may draw a rectangle or a straight line.

The number of images can be set by the user. Preferably the user decides the number of images based on required accuracy of the reconfiguration data. Usually the number of images ranges, but is not limited to, from about 4 to about 256. Obviously the X-ray inspection apparatus 100 may image the images more than 256.

In Step S413, the X-ray inspection apparatus 100 produces the reconfiguration data from the images in the plurality of directions. Various methods have been proposed in the reconfiguration processing. For example, a Feldkamp method can be used in the reconfiguration processing.

In Step S415, the X-ray inspection apparatus 100 performs the operation of soldering inspection. The specific inspection operation is described later.

In Step S417, the X-ray inspection apparatus 100 outputs the inspection result in Step S415 to the output unit 50. At this point, the inspection position (range) where the inspection target 1 is determined to be defective in the inspection and a cross-sectional image of the inspection target 1 may be displayed, the actual measured value and image may be displayed, or a message of the "defective board" may be displayed as the inspection result. A specific output example is described later.

In Step S419, the X-ray inspection apparatus 100 takes out the board to the outside thereof. Specifically, the inspection target driving mechanism 110 moves the board to the outside of the X-ray inspection apparatus 100.

Therefore, the X-ray inspection apparatus 100 ends the inspection of one inspection target 1. For the in-line inspection performed to the plurality of inspection targets 1 of the identical kind, the X-ray inspection apparatus 100 repeats the string of pieces of processing in Step S405 to Step S419 when the inspection is not ended yet for the inspection targets 1 of the identical kind (NO in Step S421). The X-ray inspection apparatus 100 ends the inspection of the inspection targets 1 of the identical kind, when the inspection is ended for all the inspection targets 1 of the identical kind (YES in Step S421).

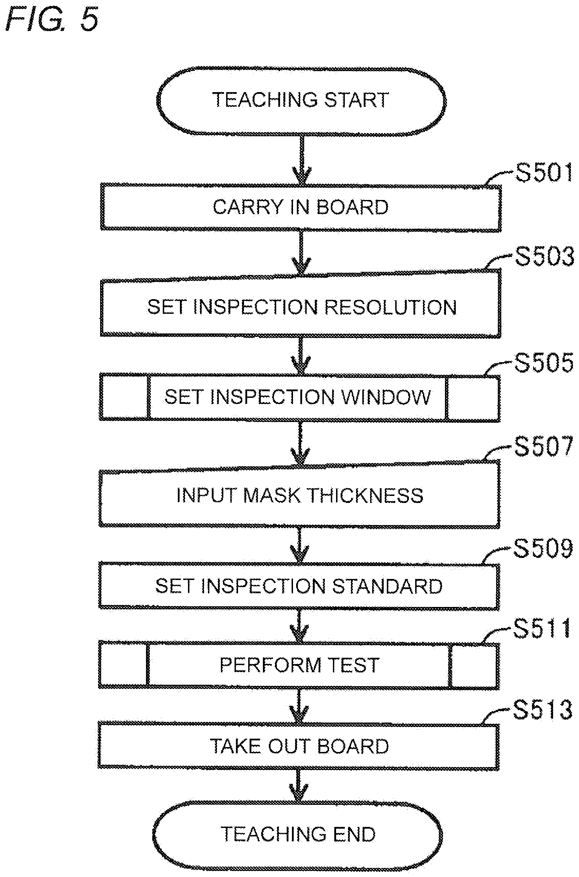

The teaching operation performed prior to the inspection will be described with reference to a flowchart of Fig. 5. The teaching operation means an operation in which the imaging region, the inspection region, and the inspection item are input and stored in the storage unit 90 prior to the inspection, For example, the operation of Fig. 5 is started when the input unit 40 receives an input to perform the manipulation for the teaching operation.

Referring to Fig. 5, when the teaching operation is started, the inspection target driving mechanism 110 carries in the board that is of a teaching target to the defined position in the X-ray inspection apparatus 100 in Step S501.

In Step S503, the input unit 40 of the X-ray inspection apparatus 100 receives the setting input of the inspection resolution.

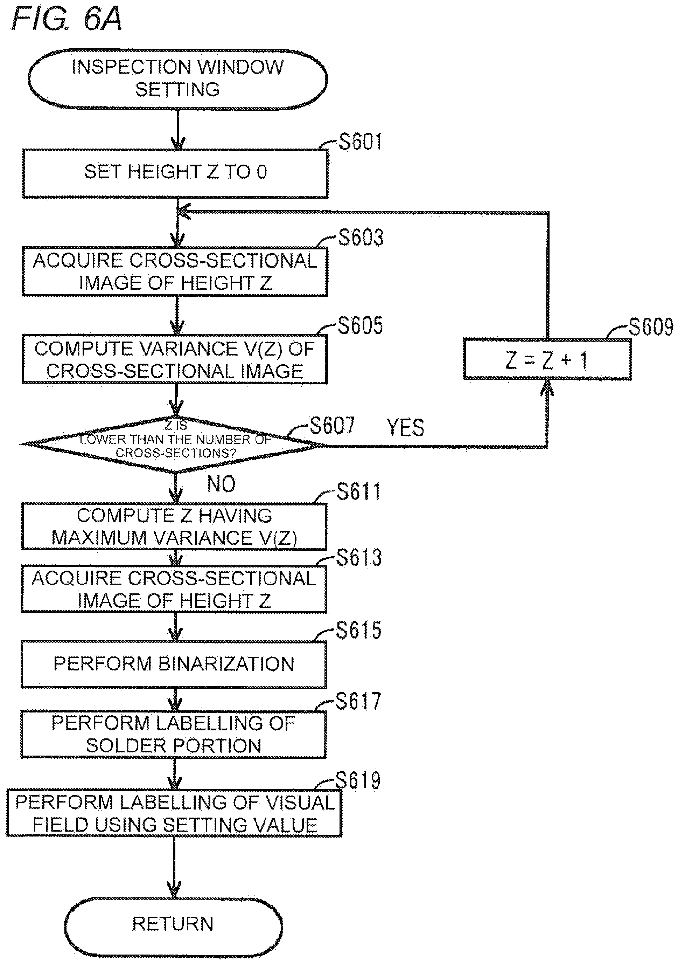

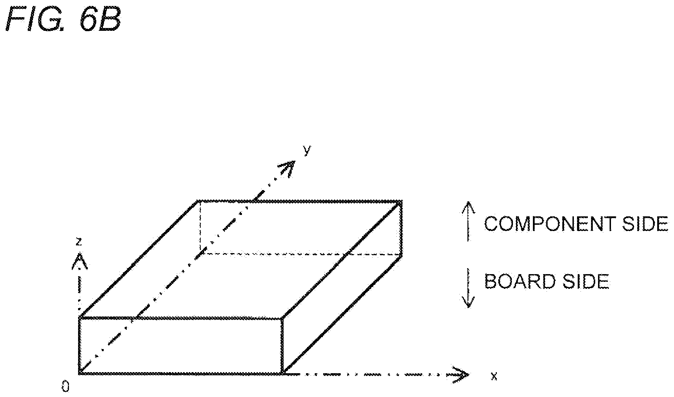

In Step S505, the X-ray inspection apparatus 100 sets an inspection window in the visual field of the inspection target 1. The inspection window is a region corresponding to one ball-shaped solder (hereinafter also referred to as a solder ball) that is previously formed on an IC side of the BGA. Various inspection window setting methods are proposed, and there is no particular limitation to the inspection window setting method. A method illustrated in Fig. 6A is used by way of example. The three-dimensional reconfiguration data produced through the reconfiguration processing has a data structure in which a plurality of cubes called boxels are arrayed, and a coordinate system of the reconfiguration data is defined as illustrated in Fig. 6B. That is, a height direction (direction normal to a surface to which the cream solder of the board is applied) is set to the Z-direction. A layer on the side close to the board is set to a cross-sectional image of Z = 0, and a Zth layer from the board side in the reconfiguration data corresponds to a cross-sectional image of Z = Z. Although preferably the cross-sectional image is a piane parallel to the board surface, it is not always necessary that the cross-sectional image be the plane parallel to the board surface. It is only necessary that the cross-sectional image is the plane crosses the normal to the board surface in the Z-direction. The parameter Z does not express the actual height. However, hereinafter the actual height assigned by the parameter Z is referred to as a height Z for the sake of convenience. It is assumed that the same holds true for the following coordinate system.

Referring to Fig. 6A, when division of the visual field is started, the X-ray inspection apparatus 100 performs pieces of processing in Step S601 to Step S613 to acquire the cross-sectional image of the height Z in which a variance V(Z) becomes the maximum. That is, the nondefective determination unit 78 substitutes 0 for the parameter Z assigning the height in a horizontal section of the object (Step S601), and the X-ray inspection apparatus 100 acquires the two-dimensional data (cross-sectional image) at the height Z from the reconfiguration data in Step S603.

In Step S605, the X-ray inspection apparatus 100 computes the variance V(Z) of the cross-sectional image at the height Z, which is acquired in Step S603. The variance of the cross-sectional image is computed by the following equation:

$$V(Z) = \Sigma x \Sigma y (Ixy - Iavg)$$

where Ixy is a luminance value of a pixel p(x, y) in the cross-sectional image and Iavg is an average luminance value of all the pixels in the cross-sectional image.

In Step S607, the X-ray inspection apparatus 100 determines whether the variance is obtained for the cross-sectional images at all the heights. Specifically, the X-ray inspection apparatus 100 determines whether Z is lower than the number of cross-sections in the reconfiguration data. When Z is lower than the number of cross-sections (YES in Step S607), the X-ray inspection apparatus 100 repeats the pieces of processing from Step S605 after the X-ray inspection apparatus 100 increments Z in Step S609. On the other hand, when Z is reaches the number of cross-sections (NO in Step S607), the X-ray inspection apparatus 100 goes to processing in Step S611.

In Step S611, the X-ray inspection apparatus 100 compares the variances V(Z) of the cross-sectional images to fix Z in which the variance V(Z) becomes the maximum. In Step S613, the X-ray inspection apparatus 100 acquires the cross-sectional image in Z in which the variance V(Z) becomes the maximum.

In Step S615, the nondefective determination unit 78 binarizes the cross-sectional image in order to divide the cross-sectional image in which the variance V(Z) becomes the maximum into a portion (solder portion) corresponding to the solder and a portion except the solder portion. A threshold of the binarization may previously be set Because there is a large difference in luminance between the solder portion and a portion (air or board) except the solder portion, the nondefective determination unit 78 can also perform the binarization using a well-known threshold setting technique such as discrimination analysis. In the following description, in the binarized image, it is assumed that the nondefective determination unit 78 changes the luminance value not lower than the threshold to 1 and changes the luminance value lower than the threshold to 0 by the binarization processing.

In Step S617, the nondefective determination unit 78 performs labeling such that a region (called bright region) including the portion having the continuous luminance value of 1 is recognized while the bright region is individually correlated with the solder ball. A well-known technique can be used as the labeling. For example, the nondefective determination unit 78 may use a technique in which raster scan and a lookup table are used or a contour tracing method. It is assumed that the user can set the neighbor pixel in the labeling. The user may set four neighbors or eight neighbors from the viewpoint of the inspection accuracy or rate.

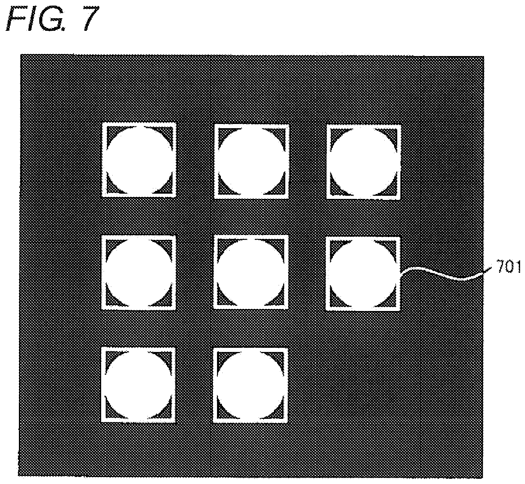

In Step S619, the nondefective determination unit 78 provides a label to a partial region corresponding to one solder ball based on the image in which the solder portion is labeled. Hereinafter the partial region is simply referred to as a "visual field" when there is a possibility that the partial region is mistakenly recognized as "post-division visual field" or "preceding-division visual field". Therefore, as illustrated in Fig. 7, a region 701 corresponding to one solder ball is set to the inspection window, and each region 701 is inspected.

In the example of Fig. 7, the region corresponding to one solder ball is set to the inspection window. Alternatively, a region corresponding to a plurality of solder balls may be set to the inspection window. In such cases, the nondefective determination unit 78 provides the label of the partial region to the predetermined number of solder portions located closes to one another in Step S619. Therefore, the one solder portion has different two labels, that is, the label of the solder portion and the label of the partial region. At this point, the nondefective determination unit 78 decides the number of solder portions included in the one inspection window based on a previously set value. For the setting of the inspection window corresponding to the plurality of solder balls, the user may previously set the number of solder portions included in the one inspection window, because usually the number of solder portions depends on a design specification of the board. Alternatively, the nondefective determination unit 78 may automatically set the number of solder portions included in the one visual field based on a solder portion distribution in the cross-sectional image.

Fig. 6A illustrates the example in which the X-ray inspection apparatus 100 sequentially obtains the variance of each cross-sectional data from the vertically lowermost cross-sectional data toward the vertically uppermost cross-sectional data. However, the procedure for fixing the variance is not limited to the example of Fig. 6A. For example, the X-ray inspection apparatus 100 may sequentially obtain the variance from the vertically uppermost cross-sectional data toward the vertically lowermost cross-sectional data.

Referring to Fig. 4, in Step S507, the input unit 40 of the X-ray inspection apparatus 100 receives a mask thickness as the cream solder thickness from the board. The inspection range is specified based on the input cream solder thickness. The cross-sectional image parallel to the surface on the side of the board on which the BGA is amounted is used in the inspection. The "inspection range" means an inspection position that is expressed by the height (distance in Z-direction) from the board surface or an inspection range that is expressed by a height range in order to specify the cross-sectional image used. The setting of the inspection range is described later. The cream solder thickness input in Step S507 may directly be stored, or the inspection range specified from the cream solder thickness may be stored. When the inspection range is stored, the inspection range is read instead of the cream solder thickness in Step S409.

When the inspection target 1 includes a plurality of reconfiguration regions (hereinafter referred to as visual fields), the X-ray inspection apparatus 100 sets the inspection range to ail the visual fields prior to the CT imaging. Setting previously the inspection range to all the visual fields can shorten the whole inspection time rather than setting the inspection range in each time of the CT imaging of the visual field.

In Step S509, the input unit 40 of the X-ray inspection apparatus 100 receives a setting of a value (hereinafter also referred to as an inspection standard value) that is used as an inspection standard. In the inspection in Step S415, the determination whether the soldering is nondefective is made by comparing the measured value from the solder portion displayed in the cross-sectional image to the inspection standard value. Accordingly, in Step S509, the input unit 40 receives an inspection standard Sth of an area or an inspection standard Tth of roundness as the inspection standard.

In Step S511, the X-ray inspection apparatus 100 examines the input and the setting by performing a test based on the input and the setting to the board that is of the carried-in inspection target 1. In Step S513, the X-ray inspection apparatus 100 takes out the board from the X-ray inspection apparatus 100.

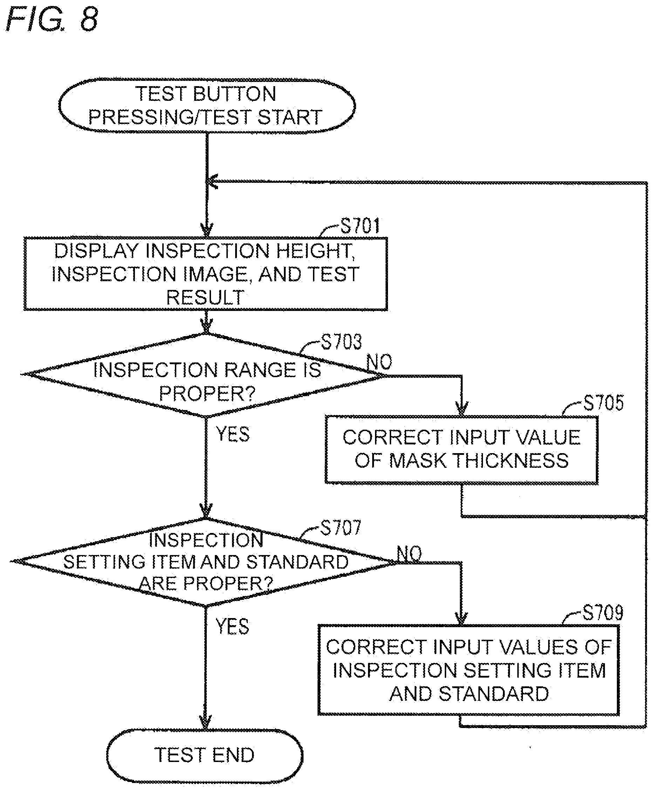

The test in Step S511 is started by pressing a test button (not illustrated) of the input unit 40. Particularly, referring to Fig. 8, when the test is started, the X-ray inspection apparatus 100 outputs the value input and set by the teaching operation to the output unit 50 in Step S701. When the following tests are already performed, the test results are displayed.

In Step S703, the input unit 40 of the X-ray inspection apparatus 100 receives an input whether the inspection height or the range of the inspection height, set as the inspection range, is proper. In Step S705, the input unit 40 receives the corrected input value of the mask thickness that is input as the cream solder thickness, when the inspection range is improper (NO in Step S703).

Similarly, in Step S707, the input unit 40 receives the input whether the input values such as the inspection resolution, the inspection window, and the inspection standard value are proper. When the input values are improper (NO in Step S707), the input unit 40 receives the corrected input values in Step S709.

When the test is ended to carry in the board in Step S513, the set standard value and the input mask thickness are stored in predetermined space of the storage unit 90 while correlated with the kind of the board. In Step S409, the nondefective determination unit 78 reads the information corresponding to the kind of the board from the storage unit 90. The kind of the board is specified by reading the information (ID) on the board that is of the carried-in inspection target 1. In the above-described example, it is assumed that the standard value and the mask thickness are stored in each kind of the board. Alternatively, the standard value and the mask thickness are stored in each board, and the nondefective determination unit 78 may read the information corresponding to the board, specified by reading the information (ID) on the board that is of the carried-in inspection target 1, from the storage unit 90 in Step S409.

The connection of the BGA to the board will be described. The BGA is connected to the board by the following method called a reflow method.

That is, in a first stage, the cream solder in which a flux is added to solder powers to acquire proper viscosity is printed in the pattern (where BGA should be mounted) on the board with a cream solder printer. In the cream solder printer, usually the cream solder is drawn on a stainless-steel paper template (metal mask) in which the holes are made using the squeeze (spatula), whereby the cream solder is transferred to the necessary point corresponding to the point in which the hole is made with the thickness of the metal mask. The thickness of the metal mask is called the "mask thickness", and the thickness of the metal mask corresponds to the thickness of the applied cream solder. In a second stage, the BGA is mounted on the pattern of the board on which the cream solder is applied with a chip mounter (surface mounter and component mounting machine). In a third stage, the heating is performed with a reflow furnace.

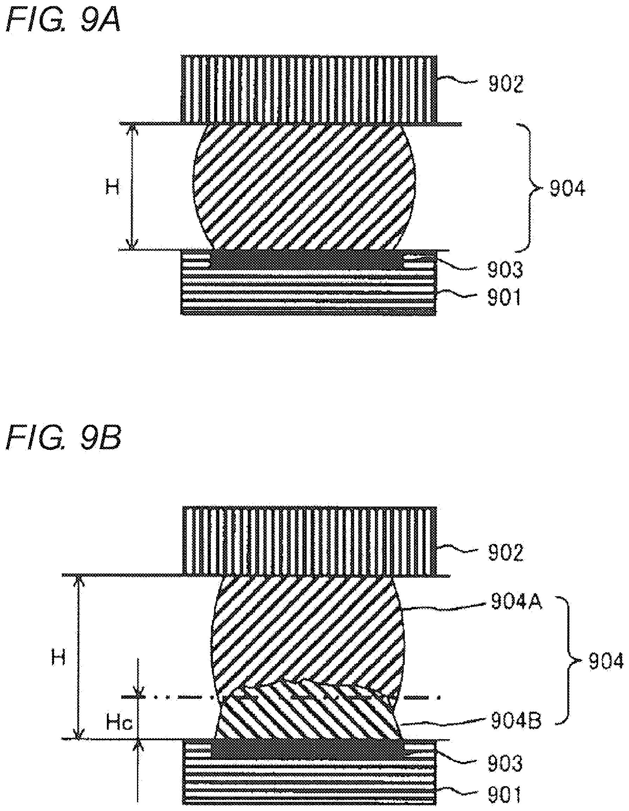

The solder ball that is previously formed on the IC side of the BGA and the cream solder are melted through the string of processes, a pattern 903 of a board 901 and a BGA 902 are physically and electrically connected by solder 904 as illustrated in Fig. 9A and Fig. 9B.

When the solder is sufficiently melted because of the proper melting temperature and proper heat transfer of the solder, the solder ball previously formed on the IC side of the BGA and the cream solder integrally form the barrel-shaped solder 904 as illustrated in Fig. 9A.

On the other hand, the solder is insufficiently melted, when the melting temperature is low, or when the heat transfer to the solder is insufficient because the solder ball of the BGA is previously oxidized. In such cases, a solder ball 904A and a cream solder 904B is incompletely integrally melted as illustrated in Fig. 9B. That is, the solder 904 is formed into the barrel shape as a whole in the example of Fig. 9A, while a discontinuous state is generated between the solder ball 904A and the cream solder 904B as illustrated in Fig. 9B. The completely physical and electrical connection state is not formed in the discontinuous state. Sometimes a void is generated in the solder 904 or the adjacent solder balls are joined to form a bridge. The completely physical and electrical connection state is not formed in these states.

Therefore, the X-ray inspection apparatus 100 performs the soldering inspection in order to inspect the solder connection state such as solder wettability, the presence or absence of the void or bridge of the solder, and the presence or absence of a foreign material in the connection of the BGA to the board that is of the inspection target 1. Particularly, the solder wettability, that is, whether the solder ball of the BGA and the cream solder is completely integrally melted is inspected based on whether the solder has the shape illustrated in Fig. 9B.

As illustrated in Fig. 9B, there is a high possibility of generating the discontinuous state between the solder ball 904A and the cream solder 904B near a position of a height Hc from the board surface. The height Hc from the board surface corresponds to the cream solder thickness from the board surface. This is because the defective connection between the components is easily generated in the boundary surface. The X-ray inspection apparatus 100 sets at least a position (Z = Hc) that is of the height Hc from the board surface to the inspection range from the mask thickness that is input as the cream solder thickness in Step S507. The height Hc from the board surface corresponds to the cream solder thickness illustrated in Fig. 9B, that is, the mask thickness. Preferably the range that includes the position (Z = He) and shorter than a distance H from the position (board surface) of the pattern 903 of the board 901 to the BGA 902 is set to the inspection range. Because the component push the board surface in mounting the component on the board surface, it is believed that a boundary between the cream solder and the solder ball is located closer to the board surface side than the height Hc from the board surface, which corresponds to the mask thickness. Accordingly, more preferably the range ($0 \leq Z \leq Hc$) from board surface to the height Hc is set to the inspection range. The solder wettability can effectively be inspected by setting the inspection range, and the inspection rate can be enhanced to improve the productivity compared with the case where the whole range ($0 \leq Z \leq H$) from the board surface to the BGA is inspected.

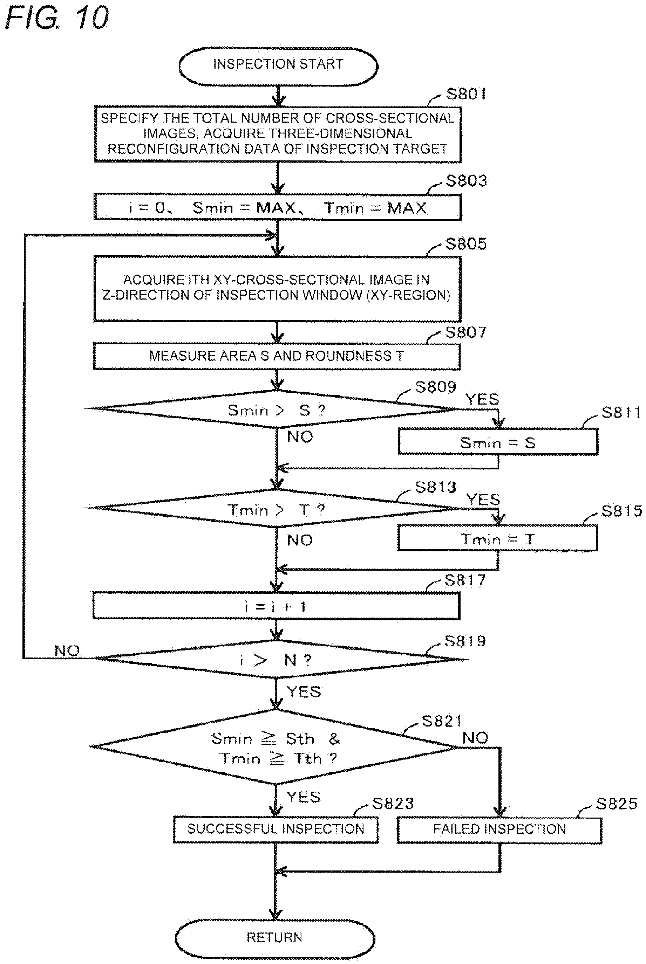

The inspection operation in Step S417 will be described with reference to Fig. 10.

Referring to Fig. 10, when the inspection operation is started, in Step S801, the nondefective determination unit 78 specifies the total number N of cross-sectional images used in the inspection from the cream solder thickness read in Step S409 and the number of height-direction boxels that form the previously defined cross-sectional image. The nondefective determination unit 78 acquires the three-dimensional reconfiguration data that is produced through the reconfiguration processing of the inspection target 1.

In Step S803, the nondefective determination unit 78 initializes a variable i indicating the order from the board side of the Z-direction cross-sectional image used in the inspection, initializes an argument Smin indicating the minimum of the solder area in the cross-sectional image to a maximum MAX that is acquired in the mounted inspection target 1, and initializes an argument Tmin indicating the minimum of the roundness of the solder portion in the cross-sectional image to a maximum MAX that is acquired in the mounted inspection target 1.

When the phenomenon in which the solder ball and the cream solder are incompletely integrally melted is generated, the positions where the cream solder is applied and the position of the solder ball are deviated from each other, whereby the cross-sectional image becomes a gourd shape or an ellipse. In the present embodiment, attention is focused on this point, a ratio of a solder area S of the cross-sectional image to an area fixed from a distance dpm between a barycentric position of the solder portion in the cross-sectional image and the boundary of the solder portion is used as an index. The "roundness" means an index of a degree of deviation from a geometric circle, the degree of deviation from the geometric circle is increased with decreasing roundness, and the degree of deviation from the geometric circle is decreased with increasing roundness, that is, the solder portion is close to the geometric circle.

The index indicating the degree of melting of the solder ball and the cream solder is not limited to the solder area of the cross-sectional image or the roundness of the solder portion of the cross-sectional image, but another index may be used. For example, an equation (1) and an equation (2) can be cited as equations for computing feature amounts F1 and F2 that are of another index:

$$F1 = dpmi^2/dpma^2 \quad \text{equation (1)}$$

$$F2 = b^2/a^2 \quad \text{equation (2)}$$

where dpma is a maximum of the distance between the barycenter and the boundary, dpmi is a minimum of the distance between the barycenter and the boundary, a is a major axis of the ellipse, and b is a minor axis of the ellipse.

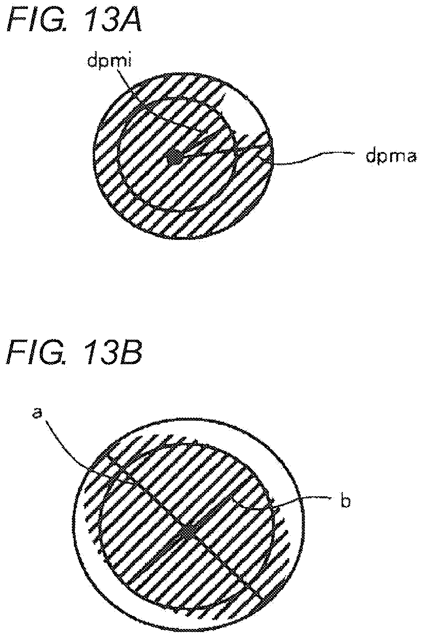

The equation (1) expresses an area ratio of an inscribed circle and a circumscribed circle, and expresses the deviation between the position of the solder ball and the position, where the cream solder is applied while the partially missing solder portion emerges in the cross-sectional image as illustrated in Fig. 13A, as the feature amount. The equation (2) expresses an area ratio of circles in which the major axis and minor axis of the ellipse are used as diameters thereof, and expresses the deviation between the position of the solder ball and the position, where the cream solder is applied while the ellipsoidal solder portion emerges in the cross-sectional image as illustrated in Fig. 13B, as the feature amount. When the solder ball and the cream solder are completely integrally melted, the circular solder portion emerges in the cross-sectional image. However, in both the feature amounts, the degree of deviation of the actual solder portion from the circle is quantified. The feature amounts are indexes expressing the phenomenon in which the solder ball and the cream solder are incompletely and integrally melted.

In Step S805, the nondefective determination unit 78 cuts out the position of Z = I from the three-dimensional data acquired in Step S801, produces the cross-sectional image, and acquires the cross-sectional image of the region corresponding to the inspection window set in Step S505. The X-ray inspection apparatus 100 binarizes the acquired cross-sectional image to acquire a binarized image in which the cross-sectional image is divided into the solder portion and the portion except the solder portion. General binarization processing such as the discrimination analysis can be used in the binarization processing. The X-ray inspection apparatus 100 performs the labeling of a white (or 1) portion from the binarized image to acquire a labeling image in which the solder portion and the portion except the solder portion are discriminated from each other. General labeling processing of determining whether the connection is established by the raster scan can be used in the labeling processing.

In Step S807, the nondefective determination unit 78 obtains the solder area S by counting each area (the number of pixels of white of 1) of the solder from the labeling image. The nondefective determination unit 78 also obtains the roundness T of the solder. The nondefective determination unit 78 compares the solder area S and the roundness T to the minimum Smin of the solder area and the minimum Tmin of the roundness, respectively. The minimum Smin of the solder area and the minimum Tmin of the roundness are stored in the past inspections.

When the solder area S obtained from the cross-sectional image of Z = i in Step S807 is lower than the minimum Smin of the solder area stored in the past inspections (YES in Step S809), the minimum Smin is updated by the fixed solder area S in Step S811. On the other hand, when the solder area S is not lower than the minimum Smin (NO in Step S809), the minimum Smin is maintained.

Similarly, when the solder roundness T obtained from the cross-sectional image of Z = i in Step S807 is lower than the minimum Tmin of the solder roundness stored in the past inspections (YES in Step S813), the minimum Tmin is updated by the obtained solder roundness T in Step S815. On the other hand, when the solder roundness T is not lower than the minimum Tmin (NO in Step S813), the minimum Tmin is maintained.

In Step S817, the nondefective determination unit 78 increments the variable i to confirm whether the variable i reaches the total number N of cross-sectional images used in the inspection set in Step S801. When the variable i does not reach the total number N of cross-sectional images (NO in Step S819), the pieces of processing from Step S805 are repeated to perform the similar pieces of processing to the next cross-sectional image.

When the variable i reaches the total number N of cross-sectional images (YES in Step S819), the nondefective determination unit 78 compares the minimum Smin of the solder area and the minimum Tmin of the roundness, which are stored in the past inspections, to the area inspection standard Sth and roundness inspection standard Tth, which are set by the teaching operation and stored in the storage unit 90, respectively (Step S821). When both the minimum Smin of the measured solder area and the minimum Tmin of the measured solder roundness are not lower than standard values (YES in Step S821), the nondefective determination unit 78 determines that the soldering state of the inspection window is nondefective and returns the determination result of the successful inspection for the inspection window in Step S823.

On the other hand, when at least one of the minimum Smin of the measured solder area and the minimum Tmin of the measured solder roundness is lower than standard values (NO in Step S821), the nondefective determination unit 78 determines that the soldering state of the inspection window is defective and returns the determination result of the failed inspection for the inspection window in Step S825.

The X-ray inspection apparatus 100 inspects all the inspection windows that are set as the inspection target 1 in Step S415. When determining the successful inspection for all the inspection windows, the nondefective determination unit 78 determines that the soldering state of the inspection target 1 is nondefective and returns the determination results of the successful inspection for the inspection target 1. On the other hand, when determining the false inspection for at least one of the inspection windows, the nondefective determination unit 78 determines that the soldering state of the inspection target 1 is defective and returns the determination results of the failed inspection for the inspection target 1.

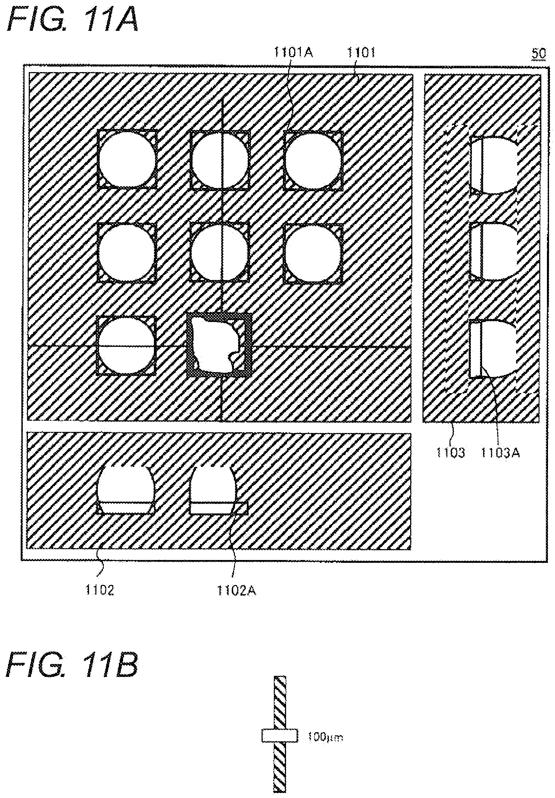

A screen illustrated in Fig. 11A is displayed on the output unit 50 as an output example in Step S417 Referring to Fig. 11A, when the determination that the soldering is defective is made in Step S415, a cross-sectional image (XY-cross-sectional image) 1101 in the Z-direction is displayed with respect to all the inspection windows of the inspection target 1 or one visual field, and each inspection window is displayed such that the solder portion and the portion except the solder portion can be distinguished from each other. Therefore, the user can recognize at a glance which defect is generated in the inspection window (position on XY-plane).

Preferably an inspection window 1101A is also displayed in the cross-sectional image 1101, and the inspection window that is determined to be defective is displayed in a manner different from that of the inspection window that is determined to be nondefective. In the example of Fig. 11A, the inspection window that is determined to be defective is displayed by a line bolder than that of the inspection window that is determined to be nondefective. Alternatively, the inspection window that is determined to be defective is displayed by a color different from that of the inspection window that is determined to be nondefective. Therefore, the user can easily recognize the inspection window (position on XY-plane) in which the defect is generated.

On the screen of Fig. 11A, the inspection window in which the defect is generated is displayed so as to be able to be selected by the input unit 40. When the input unit 40 receives the selection of the inspection window in which the defect is generated, the X-ray inspection apparatus 100 outputs the height from the board surface with respect to the cross-sectional image used in the inspection in which the defective determination is made. A slide bar illustrated in Fig. 11B is displayed as an output example of the height. In addition to the display of the height of the slide bar, the height in the Z-direction of the cross-sectional image may be displayed as illustrated in Fig. 11B. Therefore, the user can easily recognize the position (height from board surface) where the defect is generated.

Preferably, as illustrated in Fig. 11A, the output screen includes a cross-sectional image (XZ-cross-sectional image) 1102 in the Y-direction and/or a cross-sectional image (YZ cross-sectional image) 1103 in the X-direction in addition to the cross-sectional image (XY-cross-sectional image) 1101 in the Z-direction, and windows 1102A and 1103A indicating the mask thicknesses that are of the inspection ranges are displayed in the cross-sectional image (XZ cross-sectional image) 1102 in the Y-direction and/or the cross-sectional image (YZ-cross-sectional image) 1103 in the X-direction. Therefore, the user can easily recognize how much the cross-sectional image (XY-cross-sectional image) 1101 has the height in the Z-direction.

In the above description, the X-ray inspection apparatus 100 sequentially obtains the minimum Smin of the solder area and the minimum Tmin of the solder roundness in each piece of cross-sectional data from the vertically lowermost cross-sectional data toward the vertically uppermost cross-sectional data and compares the minimum Smin of the solder area and the minimum Tmin of the solder roundness to the standard values. However, the inspection procedure is not limited to the present embodiment. For example, the X-ray inspection apparatus 100 may sequentially perform the inspection from the vertically uppermost cross-sectional data toward the vertically lowermost cross-sectional data.

In the above description, by way of example, the minimum Smin of the solder area and the minimum Tmin of the solder roundness are obtained as the feature amounts in each piece of cross-sectional data, the minimum Smin of the solder area and the minimum Tmin of the solder roundness are compared to the standard values, the determination that soldering state is nondefective is made when both the minimum Smin of the solder area and the minimum Tmin of the solder roundness satisfy the standard values. However, the feature amount is not limited to the present embodiment. For example, one of the minimum Smin of the solder area and the minimum Tmin of the solder roundness, other feature amounts, or a combination thereof may be used as the feature amount. The feature amounts computed by the equations (1) and (2) may be used as other feature amounts.

In the above description, the X-ray inspection apparatus 100 produces the plurality of pieces of cross-sectional data from the reconfigured three-dimensional data. Alternatively, the X-ray inspection apparatus 100 may produces the plurality of pieces of cross-sectional data at intervals in which the inspection operation can be performed within the inspection standard. The X-ray inspection apparatus 100 needs not to reconfigure the pieces of data of all the boxels in the visual field.

[Other Embodiment 1]

In the above description, the board on which the BGA is mounted is inspected. However, the object that can be inspected with the X-ray inspection apparatus 100 is not limited to the board on which the BGA is mounted. The X-ray inspection apparatus 100 can similarly be used in the inspections for other components. Because the defective connection between the components is generated in the boundary surface, the boundary surface can previously be specified as the inspection range. Therefore, the inspection range is set from the boundary surface, and the determination of the defective connection can similarly be made by the inspection within the inspection range. When the inspection target is the board on which the BGA is mounted, a boundary surface between the solder ball provided in the BGA and the cream solder printed in the board and a boundary surface between the board surface and the cream solder can be cited as an example of the boundary surface. When the inspection target is the board on which a component such as a chip in which the solder ball is not provided unlike the BGA is mounted, a boundary surface between an electrode of the component and the cream solder printed in the board can be cited as an example of the boundary surface.

[Other Embodiment 2]

In the above description, the connection state of the solder between the BGA and the board is inspected in the board on which the BGA is mounted. Inspection contents of the X-ray inspection apparatus 100 are not limited to the connection state of the solder, but the X-ray inspection apparatus 100 can similarly be used in another inspection. An inspection of the presence or absence of the void in the solder joining the BGA and the board can be cited as an example of another inspection.

Because the void is generated by a chemical reaction of materials in the boundary surface, the boundary surface between the solder ball provided in the BGA and the cream solder printed in the board can be specified as the height at which the void is easily generated. Therefore, the inspection range is similarly set from the cream solder thickness that is input as the mask thickness, and the presence or absence of the void is inspected within the inspection range.

[Other Embodiment 3]

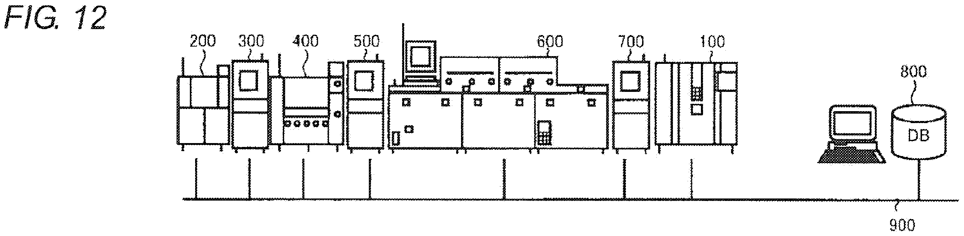

In the above description, by way of example, the mask thickness input by the user is received to acquire the cream solder thickness and the inspection range is set in the teaching operation. The acquisition of the cream solder thickness is not limited to the input from the user, but the cream solder thickness may be acquired by another method. For example, it is assumed that the process of connecting the BGA to the board, described above as the first stage to third stage, is automatically performed by a system including an apparatus group illustrated in Fig. 12. Referring to Fig. 12, the system includes a cream solder printer 200 that prints the cream solder in the pattern on the board, an inspection machine 300 that inspects the solder printing state, a chip mounter 400 that mounts the BGA on the pattern of the board to which the cream solder is applied, an inspection machine 500 that inspects the BGA mounting state, a reflow furnace 600, a inspection machine 700 that inspects an appearance of the soldering state, and the X-ray inspection apparatus 100. The board is conveyed in this order, and the BGA is connected through the first stage to the third stage, The inspection machines 300, 500, 700, and 100 are included between the pieces of apparatus of the processes in this order, the Inspection machines 300, 500, 700, and 100 make the nondefective determination of the preceding process by measuring the board passing through the preceding process. As illustrated in Fig. 12, the system may further include a server 800, and the pieces of apparatus of the system are connected through a communication line 900. The communication line 900 may be a LAN (Local Area Network) cable of about 1 Gbit, a telephone line such as the Internet, or a wireless communication line.

The inspection machine 300 that is of a printing inspection apparatus performs the three-dimensional measurement with a stereo camera to the board to which the printing process is already performed by the cream solder printer 200, and the inspection machine 300 measures the amount (volume or height) of solder printed in each pad (inspection point) on the board. The inspection machine 300 compares each measured value to a previously registered standard value to determine whether the solder amount of each pad is proper, excessive, or low in each pad. The inspection machine 300 transmits the inspection result or the measured data acquired by measurement processing performed in the inspection in each time the inspection of one board is ended. The transmitted information includes at least the measured data (measured solder amount) that is correlated with the identification information on the corresponding board. Preferably the measured data of the transmitted information is correlated with identification information (for example, pad ID) on the corresponding measured point.

In the system of Fig. 12, the X-ray inspection apparatus 100 may acquire the cream solder thickness by receiving the information transmitted from the inspection machine 300 through the communication line 900 instead of the input from the user in the teaching operation. Therefore, when the cream solder thickness is acquired from the inspection machine 300 through the communication fine 900, the human error can be avoided to improve the inspection accuracy compared with the input of the user. Additionally, the process of the teaching operation can be reduced to improve the inspection efficiency.

When the measured data is transmitted from the inspection machine 300 in each inspection point (pad) on the board, the X-ray inspection apparatus 100 may specify the inspection position in the Z-direction in each inspection point to perform the inspection using the corresponding cross-sectional image. Sometimes the thickness of the printed cream solder varies according to the point even in the board by adjustment of a pressure of the squeeze or a degree of pressing component by the mounter. The cream solder thickness measured in each inspection point on the board is input from the inspection machine 300 to the X-ray inspection apparatus 100, which allows the optimum inspection position in the Z-direction to be specified in each inspection point. Therefore, the inspection accuracy can further be improved.

At this point, the cream solder thickness of the initial board measured in each kind of the carried-in board by the inspection machine 300 may be used, or the cream solder thickness measured in each board by the inspection machine 300 may be used. When the inspection range is defined using the cream solder thickness measured in each board, the inspection accuracy can be improved while the inspection rate is secured. In such cases, the X-ray inspection apparatus 100 receives the ID unique to the board read by the inspection machine 300 and the cream solder thickness from the inspection machine 300 while the ID and the cream solder thickness are correlated with each other, and stores the ID and the cream solder thickness. The ID and the cream solder thickness may be stored in the server 800. The ID is read from the inspection target 1 carried in the X-ray inspection apparatus 100, and the cream solder thickness correlated with the ID is used to define the inspection range.

Instead of the reception from the inspection machine 300, the measurement result of the board on which the BGA is already mounted by the chip mounter 400 may be received from the inspection machine 500 to acquire the cream solder thickness from the measurement result. The mask thickness which is previously stored in the server 800 and included in CAD (Computer Aided Design) data of the metal mask used in the cream solder printer 200 may be read and used instead of the measurement result. When the cream solder thickness is received and acquired in the above-described way, compared with the input of the user, the human error can be avoided to improve the inspection accuracy. Additionally, the process of the teaching operation can be reduced to improve the inspection efficiency.

In the inspection machine 500, the board on which the component is already mounted is similarly measured in each inspection point on the board, and the measurement result may be input to the X-ray inspection apparatus 100 while correlated with the identification information of the corresponding measured point. In such cases, the X-ray inspection apparatus 100 may specify the inspection position in the Z-direction in each inspection point to perform the inspection using the corresponding cross-sectional image. With this configuration, the optimum inspection position in the Z-direction can be specified in each inspection point, the inspection accuracy can further be improved.

The embodiments are disclosed only by way of example, and the invention is not limited to the disclosed embodiments. The scope of the invention is determined by not the description but claims, and the meanings equivalent to claims and all changes within the scope of claims are included in the invention.

## Claims

1. An X-ray inspection apparatus (100) configured to inspect an object using an X-ray, the object including a substrate and a component that is mounted on the substrate and electrically connected to the substrate by solder applied on the substrate, the X-ray inspection apparatus (100) comprising:

   an X-ray output unit (10) configured to output the X-ray toward the object;
   an X-ray detecting unit (23) configured to image a perspective image indicating an intensity distribution of the X-ray being incident to the object from a plurality of directions and transmitted through the object; and
   a reconstruction unit (76) configured to reconstruct a cross-sectional image of a region between the component and the substrate based on the perspective image of the X-ray from the plurality of directions, the region crossing a normal line to a surface of the substrate on which the component is mounted,
   **characterized by**
   an acquisition unit (30) configured to acquire a thickness of the solder applied on the substrate;
   a specifying unit (80) configured to specify, based on the thickness of the solder, a position prescribed by a distance in a direction normal to the surface of the substrate on which the component is mounted as an inspection position of the object;

a first inspection unit (78) configured to determine whether the connection of the object by the solder is nondefective using the cross-sectional image located in the inspection position;
a storage unit in which the thickness of the solder applied on the substrate is stored and correlated with identification information on the substrate; and
an identification unit configured to identify the substrate,

wherein the specifying unit is configured to read the thickness of the solder, which is correlated with the identification information on the substrate of the object, and to specify the inspection position of the object.

2. The X-ray inspection apparatus (100) according to claim 1, wherein the specifying unit (80) is configured to specify at least a range as the inspection position, the range including a position prescribed by a distance corresponding to a thickness of the solder in the direction normal to the surface of the substrate on which the component is mounted, and being shorter than a distance between the substrate and the component.

3. The X-ray inspection apparatus (100) according to claim 2, wherein the specifying unit (80) is configured to specify a range from the surface of the substrate on which the component is mounted to a position corresponding to the thickness of the solder in the direction normal to the surface of the substrate on which the component is mounted as the inspection position.

4. The X-ray inspection apparatus (100) according to claim 1, wherein the acquisition unit (30) includes an input unit configured to receive an input of the thickness of the solder applied on the substrate.

5. The X-ray inspection apparatus (100) according to claim 1, wherein the acquisition unit (30) is configured to acquire data indicating the thickness of the solder applied on the substrate from a device configured to measure the thickness of the solder on the substrate.

6. The X-ray inspection apparatus (100) according to claim 1, wherein the acquisition unit (30) is configured to acquire data indicating the thickness of the solder applied on the substrate from a device configured to store a measurement result of the thickness of the solder on the substrate in a device configured to measure the thickness of the solder on the substrate.

7. The X-ray inspection apparatus (100) according to claim 1, wherein the identification information is identification information unique to the object.

8. The X-ray inspection apparatus (100) according to claim 1, wherein the identification information is identification information unique to a kind of the object.

9. The X-ray inspection apparatus (100) according to claim 1, wherein the first inspection unit (78) is configured to determine whether the connection by the solder is nondefective using one of an area, roundness, and other feature amounts of a solder portion expressed in the cross-sectional image located in the inspection position or a combination thereof, the other feature amounts of the solder portion are feature amounts quantifying a degree of deviation of the solder portion from a circle.

10. An X-ray inspection method for inspecting an object using an X-ray, the object including a substrate and a component that is mounted on the substrate and electrically connected to the substrate by solder applied on the substrate, the X-ray inspection method comprising the steps of:

acquiring a thickness of the solder applied on the substrate included in the object;
outputting the X-ray toward the object;
imaging a perspective image indicating an intensity distribution of the X-ray being incident to the object from a plurality of directions and transmitted through the object; and
reconstructing a cross-sectional image of a region between the component and the substrate based on the perspective image of the X-ray from the plurality of directions, the region crossing a normal line to a surface of the substrate on which the component is mounted,
**characterized by**
specifying, based on the thickness of the solder, a position prescribed by a distance in a direction normal to the surface of the substrate on which the component is mounted as an inspection position of the object;

determining whether the connection of the object by the solder is nondefective using the cross-sectional image located in the inspection position
identifying the substrate;
storing the thickness of the solder applied on the substrate; and

correlating the thickness with identification information on the substrate,

wherein the step of specifying comprises: reading the thickness of the solder, which is correlated with the identification information on the substrate of the object; and specifying the inspection position of the object.

11. A computer readable medium storing a computer program which, when executed on a computer, executes the steps of the X-ray inspection method according to claim 10.

12. An X-ray inspection system comprising:

a first inspection apparatus (300) configured to inspect a substrate on which solder is applied; and an X-ray inspection apparatus (100) as claimed in claim 1 wherein the object in the X-ray inspection apparatus (100) includes the substrate and a component that is mounted on the substrate and electrically connected to the substrate by the solder applied on the substrate,

the first inspection apparatus includes:

a second inspection unit configured to measure an amount of the solder applied on the substrate and to produce measurement result data of the substrate, the measurement result being correlated with identification information identifying the substrate in the measurement result data; and a communication unit (900) configured to transmit the measurement result data.

13. The X-ray inspection system according to claim 12, wherein

the second inspection unit of the first inspection apparatus is configured to measure an applied solder amount at each inspection point on the substrate to produce measurement result data at each inspection point, and the specifying unit of the X-ray inspection apparatus (100) is configured to specify the inspection position at each inspection point on the substrate.

**Patentansprüche**

1. Röntgenuntersuchungsgerät (100), das konfiguriert ist, ein Objekt unter Verwendung eines Röntgenstrahls zu untersuchen, wobei das Objekt ein Substrat und eine Komponente enthält, die auf dem Substrat angebracht ist und durch auf das Substrat aufgebrachtes Lot elektrisch mit dem Substrat verbunden ist, wobei das Röntgenuntersuchungsgerät (100) umfasst:

eine Röntgenstrahlausgabeeinheit (10), die konfiguriert ist, den Röntgenstrahl in Richtung des Objekts auszugeben; eine Röntgenstrahlerkennungseinheit (23), die konfiguriert ist, ein perspektivisches Bild abzubilden, das eine Intensitätsverteilung des Röntgenstrahls anzeigt, der von mehreren Richtungen auf das Objekt einfällt und durch das Objekt transmittiert wird; und eine Wiederherstellungseinheit (76), die konfiguriert ist, ein Querschnittsbild einer Region zwischen der Komponente und dem Substrat auf der Grundlage des perspektivischen Bildes des Röntgenstrahls von den mehreren Richtungen wiederherzustellen, wobei die Region eine Linie, die senkrecht zu einer Oberfläche des Substrats ist, auf dem die Komponente angebracht ist, schneidet, **gekennzeichnet durch** eine Erfassungseinheit (30), die konfiguriert ist, eine Dicke des auf dem Substrat aufgebrachten Lots zu erfassen; eine Festlegungseinheit (80), die konfiguriert ist, auf der Grundlage der Dicke des Lots eine Position, die durch eine Entfernung in einer Richtung senkrecht zur Oberfläche des Substrats vorgeschrieben ist, auf dem die Komponente angebracht ist, als eine Untersuchungsposition des Objekts festzulegen; eine erste Untersuchungseinheit (78), die konfiguriert ist, unter Verwendung des Querschnittsbildes, das sich in der Untersuchungsposition befindet, zu bestimmen, ob die Verbindung des Objekts durch das Lot fehlerfrei ist; eine Speichereinheit, in der die Dicke des auf dem Substrat aufgebrachten Lots gespeichert ist und mit Identifizierungsinformationen auf dem Substrat korreliert ist; und eine Identifizierungseinheit, die konfiguriert ist, das Substrat zu identifizieren, wobei die Festlegungseinheit konfiguriert ist, die Dicke des Lots auszulesen, die mit den Identifizierungsinformationen auf dem Substrat des Objekts korreliert ist, und die Untersuchungsposition des Objekts festzulegen.

2. Röntgenuntersuchungsgerät (100) nach Anspruch 1, wobei die Festlegungseinheit (80) konfiguriert ist, wenigstens einen Bereich als die Untersuchungsposition festzulegen, wobei der Bereich eine Position enthält, die durch eine Entfernung vorgeschrieben ist, welche einer Dicke des Lots in der Richtung senkrecht zu der Oberfläche des Substrats, auf dem die Komponente angebracht ist, entspricht, und kürzer als eine Entfernung zwischen dem Substrat und der Komponente ist.

3. Röntgenuntersuchungsgerät (100) nach Anspruch 2, wobei die Festlegungseinheit (80) konfiguriert ist, einen Bereich von der Oberfläche des Substrats, auf dem die Komponente angebracht ist, zu einer Position, die der Dicke des Lots in der Richtung senkrecht zu der Oberfläche des Substrats, auf dem die Komponente angebracht ist, entspricht, als die Untersuchungsposition festzulegen.

4. Röntgenuntersuchungsgerät (100) nach Anspruch 1, wobei die Erfassungseinheit (30) eine Eingabeeinheit enthält, die konfiguriert ist, eine Eingabe der Dicke des auf dem Substrat aufgebrachten Lots zu empfangen.

5. Röntgenuntersuchungsgerät (100) nach Anspruch 1, wobei die Erfassungseinheit (30) konfiguriert ist, Daten, die die Dicke des auf dem Substrat aufgebrachten Lots anzeigen, von einer Vorrichtung zu erfassen, die konfiguriert ist, die Dicke des Lots auf dem Substrat zu messen.

6. Röntgenuntersuchungsgerät (100) nach Anspruch 1, wobei die Erfassungseinheit (30) konfiguriert ist, Daten, die die Dicke des auf dem Substrat aufgebrachten Lots anzeigen, von einer Vorrichtung zu erfassen, die konfiguriert ist, ein Messergebnis der Dicke des Lots auf dem Substrat in einer Vorrichtung zu speichern, die konfiguriert ist, die Dicke des Lots auf dem Substrat zu messen.

7. Röntgenuntersuchungsgerät (100) nach Anspruch 1, wobei die Identifizierungsinformationen Identifizierungsinformationen sind, die eindeutig für das Objekt sind.

8. Röntgenuntersuchungsgerät (100) nach Anspruch 1, wobei die Identifizierungsinformationen Identifizierungsinformationen sind, die für eine Art des Objekts eindeutig sind.

9. Röntgenuntersuchungsgerät (100) nach Anspruch 1, wobei die erste Untersuchungseinheit (78) konfiguriert ist, unter Verwendung eines Bereichs, einer Rundung oder anderer Merkmalsmengen eines Lotabschnitts, die in dem Querschnittsbild, das sich in der Untersuchungsposition befindet, ausgedrückt sind, oder einer Kombination davon zu bestimmen, ob die Verbindung durch das Lot fehlerfrei ist, wobei die anderen Merkmalsmengen des Lotabschnitts Merkmalsmengen sind, die einen Grad einer Abweichung des Lotabschnitts von einem Kreis quantifizieren.

10. Röntgenuntersuchungsverfahren zum Untersuchen eines Objekts unter Verwendung eines Röntgenstrahls, wobei das Objekt ein Substrat und eine Komponente enthält, die auf dem Substrat angebracht ist und durch auf das Substrat aufgebrachtes Lot elektrisch mit dem Substrat verbunden ist, wobei das Röntgenuntersuchungsverfahren die Schritte umfasst:

Erfassen einer Dicke des auf dem Substrat, das im Objekt enthalten ist, aufgebrachten Lots;
Ausgeben des Röntgenstrahls in Richtung des Objekts;
Abbilden eines perspektivischen Bildes, das eine Intensitätsverteilung des Röntgenstrahls anzeigt, der von mehreren Richtungen auf das Objekt einfällt und durch das Objekt transmittiert wird; und
Wiederherstellen eines Querschnittsbilds einer Region zwischen der Komponente und dem Substrat auf der Grundlage des perspektivischen Bildes des Röntgenstrahls von den mehreren Richtungen, wobei die Region eine Linie, die senkrecht zu einer Oberfläche des Substrats ist, auf dem die Komponente angebracht ist, schneidet,
**gekennzeichnet durch**
Festlegen, auf der Grundlage der Dicke des Lots, einer Position, die durch eine Entfernung in einer Richtung senkrecht zu der Oberfläche des Substrats vorgeschrieben ist, auf dem die Komponente angebracht ist, als eine Untersuchungsposition des Objekts;
Bestimmen, unter Verwendung des Querschnittsbildes, das sich in der Untersuchungsposition befindet, ob die Verbindung des Objekts durch das Lot fehlerfrei ist;
Identifizieren des Substrats;
Speichern der Dicke des Lots, das auf dem Substrat aufgebracht ist; und
Korrelieren der Dicke mit Identifizierungsinformationen auf dem Substrat,
wobei der Schritt des Festlegens umfasst:
Auslesen der Dicke des Lots, die mit den Identifizierungsinformationen auf dem Substrat des Objekts korreliert ist; und
Festlegen der Untersuchungsposition des Objekts.

11. Computerlesbares Medium, das ein Computerprogramm speichert, welches, wenn es auf einem Computer ausgeführt wird, die Schritte des Röntgenuntersuchungsverfahrens nach Anspruch 10 ausführt.

12. Röntgenuntersuchungssystem, umfassend:

ein erstes Untersuchungsgerät (300), das konfiguriert ist, ein Substrat, auf dem Lot aufgebracht ist, zu untersuchen; und
ein Röntgenuntersuchungsgerät (100) nach Anspruch 1, wobei das Objekt in dem Röntgenuntersuchungsgerät (100) das Substrat und eine Komponente enthält, die auf dem Substrat angebracht ist und durch das auf das Substrat aufgebrachte Lot elektrisch mit dem Substrat verbunden ist, das erste Untersuchungsgerät enthält:

eine zweite Untersuchungseinheit, die konfiguriert ist, eine Menge des auf dem Substrat aufgebrachten Lots zu messen und Messergebnisdaten des Substrats zu erzeugen, wobei das Messergebnis mit Identifizierungsinformationen, die das Substrat identifizieren, in den Messergebnisdaten korreliert ist; und
eine Kommunikationseinheit (900), die konfiguriert ist, die Messergebnisdaten zu übertragen.

13. Röntgenuntersuchungssystem nach Anspruch 12, wobei
die zweite Untersuchungseinheit des ersten Untersuchungsgeräts konfiguriert ist, eine aufgebrachte Lotmenge an jedem Untersuchungspunkt auf dem Substrat zu messen, um Messergebnisdaten an jedem Untersuchungspunkt zu erzeugen, und
die Festlegungseinheit des Röntgenuntersuchungsgeräts (100) konfiguriert ist, die Untersuchungsposition an jedem Untersuchungspunkt auf dem Substrat festzulegen.

**Revendications**

1. Appareil d'inspection à rayons X (100) configuré pour inspecter un objet à l'aide de rayons X, l'objet incluant un substrat et un composant qui est monté sur le substrat et électriquement connecté au substrat par brasure appliquée sur le substrat, l'appareil d'inspection à rayons X (100) comprenant :

une unité de sortie de rayons X (10) configurée pour fournir en sortie le rayon X vers l'objet ;
une unité de détection de rayons X (23) configurée pour imager une image respective indiquant une distribution d'intensité des rayons X incidents sur l'objet depuis une pluralité de directions et transmis à travers l'objet ; et
une unité de reconstruction (76) configurée pour reconstruire une image en coupe transversale d'une région entre le composant et le substrat d'après l'image en perspective des rayons X provenant de la pluralité de directions, la région coupant une droite normale à une surface du substrat sur lequel est monté le composant,

**caractérisé par**
une unité d'acquisition (30) configurée pour acquérir une épaisseur de la brasure appliquée sur le substrat ;
une unité de spécification (80) configurée pour spécifier, d'après l'épaisseur de la brasure, une position prescrite par une distance dans une direction normale à la surface du substrat sur lequel est monté le composant en tant que position d'inspection de l'objet ;
une première unité d'inspection (78) configurée pour déterminer si la connexion de l'objet par la brasure est non défectueuse à l'aide de l'image en coupe transversale située dans la position d'inspection ;
une unité de stockage dans laquelle l'épaisseur de la brasure appliquée sur le substrat est stockée et corrélée à des informations d'identification sur le substrat ; et
une unité d'identification configurée pour identifier le substrat,
dans lequel l'unité de spécification est configurée pour lire l'épaisseur de la brasure, qui est corrélée aux informations d'identification sur le substrat de l'objet, et spécifier la position d'inspection de l'objet.

2. Appareil d'inspection à rayons X (100) selon la revendication 1, dans lequel l'unité de spécification (80) est configurée pour spécifier au moins une plage en tant que position d'inspection, la plage incluant une position prescrite par une distance correspondant à une épaisseur de la brasure dans la direction normale à la surface du substrat sur lequel est monté le composant, et étant plus courte qu'une distance entre le substrat et le composant.

3. Appareil d'inspection à rayons X (100) selon la revendication 2, dans lequel l'unité de spécification (80) est configurée pour spécifier une plage allant de la surface du substrat sur lequel est monté le composant à une position correspondant à l'épaisseur de la brasure dans une direction normale à la surface du substrat sur lequel est monté le composant en tant que position d'inspection.

4. Appareil d'inspection à rayons X (100) selon la revendication 1, dans lequel l'unité d'acquisition (30) inclut une unité d'entrée configurée pour recevoir une entrée de l'épaisseur de la brasure appliquée sur le substrat.

5. Appareil d'inspection à rayons X (100) selon la revendication 1, dans lequel l'unité d'acquisition (30) est configurée pour acquérir des données indiquant l'épaisseur de la brasure appliquée sur le substrat à partir d'un dispositif configuré pour mesurer l'épaisseur de la brasure sur le substrat.

**6.** Appareil d'inspection à rayons X (100) selon la revendication 1, dans lequel l'unité d'acquisition (30) est configurée pour acquérir des données indiquant l'épaisseur de la brasure appliquée sur le substrat à partir d'un dispositif configuré pour stocker un résultat de mesure de l'épaisseur de la brasure sur le substrat dans un dispositif configuré pour mesurer l'épaisseur de la brasure sur le substrat.

**7.** Appareil d'inspection à rayons X (100) selon la revendication 1, dans lequel les informations d'identification sont des informations d'identification propres à l'objet.

**8.** Appareil d'inspection à rayons X (100) selon la revendication 1, dans lequel les informations d'identification sont des informations d'identification propres à une sorte de l'objet.

**9.** Appareil d'inspection à rayons X (100) selon la revendication 1, dans lequel la première unité d'inspection (78) est configurée pour déterminer si la connexion par la brasure est non défectueuse à l'aide de l'une parmi une aire, une rondeur, et d'autres quantités de particularité d'une portion de brasure exprimée dans l'image en coupe transversale située dans la position d'inspection ou l'une de leur combinaison, les autres quantités de particularité de la portion de brasure sont des quantités de particularité quantifiant un degré d'écart de la portion de brasure par rapport à un cercle.

**10.** Méthode d'inspection à rayons X destinée à inspecter un objet à l'aide de rayons X, l'objet incluant un substrat et un composant qui est monté sur le substrat et électriquement connecté au substrat par la brasure appliquée sur le substrat, la méthode d'inspection à rayons X comprenant les étapes de :

acquisition d'une épaisseur de la brasure appliquée sur le substrat inclus dans l'objet ;
fourniture en sortie des rayons X vers l'objet ;
formation d'une image en perspective indiquant une distribution d'intensité des rayons X qui sont incidents sur l'objet depuis une pluralité de directions et transmis à travers l'objet ; et
reconstruction d'une image en coupe transversale d'une région entre le composant et le substrat d'après l'image en perspective des rayons X depuis la pluralité de directions, la région coupant une droite normale à une surface du substrat sur lequel est monté le composant,
**caractérisé par**
la spécification, d'après l'épaisseur de la brasure, d'une position prescrite par une distance dans une direction normale à la surface du substrat sur lequel est monté le composant en tant que position d'inspection de l'objet ;

le fait de déterminer si la connexion de l'objet par la brasure est non défectueuse à l'aide de l'image en coupe transversale située dans la position d'inspection
l'identification du substrat ;
le stockage de l'épaisseur de la brasure appliquée sur le substrat ; et
la corrélation de l'épaisseur avec des informations d'identification sur le substrat,
dans lequel l'étape de spécification comprend :

la lecture de l'épaisseur de la brasure, qui est corrélée aux informations d'identification sur le substrat de l'objet ; et
la spécification de la position d'inspection de l'objet.

**11.** Support lisible par ordinateur stockant un programme d'ordinateur qui, lorsqu'il est exécuté sur un ordinateur, exécute les étapes de la méthode d'inspection à rayons X selon la revendication 10.

**12.** Système d'inspection à rayons X comprenant :

un premier appareil d'inspection (300) configuré pour inspecter un substrat sur lequel est appliquée de la brasure ; et
un appareil d'inspection à rayons X (100) tel que revendiqué dans la revendication 1, dans lequel l'objet dans l'appareil d'inspection à rayons X (100) inclut le substrat et un composant qui est monté sur le substrat et électriquement connecté au substrat par la brasure appliquée sur le substrat,
le premier appareil d'inspection inclut :

une seconde unité d'inspection configurée pour mesurer une quantité de la brasure appliquée sur le substrat et produire des données de résultat de mesure du substrat, le résultat de mesure étant corrélé à des informations d'identification identifiant le substrat dans les données de résultat de mesure ; et
une unité de communication (900) configurée pour transmettre les données de résultat de mesure.

**13.** Système d'inspection à rayons X selon la revendication 12, dans lequel
la seconde unité d'inspection du premier appareil d'inspection est configurée pour mesurer une quantité de brasure appliquée à chaque point d'inspection sur le substrat pour produire des données de résultat de mesure à chaque point d'inspection, et
l'unité de spécification de l'appareil d'inspection à rayons X (100) est configurée pour spécifier la position d'inspection à chaque point d'inspection sur le substrat.

## FIG. 1

**100**

X-RAY DETECTOR DRIVING UNIT — 22

X-RAY DETECTOR — 23

18

110

1

10

**IMAGE ACQUISITION CONTROL MECHANISM** — 30

32

DETECTOR DRIVING CONTROL MECHANISM

IMAGE DATA ACQUISITION UNIT — 34

INSPECTION TARGET POSITION CONTROL MECHANISM — 120

INPUT UNIT — 40

OUTPUT UNIT — 50

X-RAY SOURCE CONTROL MECHANISM — 60

**ARITHMETIC UNIT** — 70

X-RAY SOURCE CONTROLLER — 72

X-RAY FOCAL POSITION COMPUTING UNIT — 82

IMAGE ACQUISITION CONTROLLER — 74

IMAGING CONDITION SETTING UNIT — 84

RECONFIGURATION UNIT — 76

NONDEFECTIVE DETERMINATION UNIT — 78

INSPECTION TARGET POSITION CONTROLLER — 80

**SGE UNITTORA** — 90

X-RAY FOCAL POSITION INFORMATION — 92

PROGRAM — 96

IMAGING CONDITION INFORMATION — 94

IMAGE DATA — 98

EP 2 365 320 B1

18

FIG. 2

FIG. 3

112

COMPONENT (BGA)

PRINTED BOARD

112

## FIG. 4

```
        ┌─────────────────────┐
        │     INSPECTION      │
        │       START         │
        └─────────────────────┘
                  │
                  ▼                        ⌐S401
        ┌─────────────────────────────────────┐
        │      SELECT KIND OF BOARD           │
        └─────────────────────────────────────┘
                  │                        ⌐S403
                  ▼
        ┌─────────────────────────────────────┐
        │    LOAD CONDITION AND STANDARD      │
        └─────────────────────────────────────┘
                  │
                  ▼                        ⌐S405
        ┌─────────────────────────────────────┐
        │        CARRY IN BOARD               │
        └─────────────────────────────────────┘
                  │                        ⌐S407
                  ▼
        ┌─────────────────────────────────────┐
        │         READ BOARD ID               │
        └─────────────────────────────────────┘
                  │                        ⌐S409
                  ▼
        ┌─────────────────────────────────────┐
        │  ACQUIRE CORRESPONDING BOARD AND    │
        │      SOLDER HEIGHT OF PAD           │
        └─────────────────────────────────────┘
                  │                        ⌐S411
                  ▼
        ┌─────────────────────────────────────┐
        │     IMAGE A PLURALITY OF X-RAY      │
        │        PERSPECTIVE IMAGES           │
        └─────────────────────────────────────┘
                  │                        ⌐S413
                  ▼
        ┌─────────────────────────────────────┐
        │  PRODUCE THREE-DIMENSIONAL DATA (CT)│
        └─────────────────────────────────────┘
                  │                        ⌐S415
                  ▼
        ┌─────────────────────────────────────┐
        │     INSPECT OF SOLDERING OF BGA     │
        └─────────────────────────────────────┘
                  │                        ⌐S417
                  ▼
        ┌─────────────────────────────────────┐
        │OUTPUT AND DISPLAY HEIGHT AND XY-CROSS-SECTIONAL│
        │IMAGE OF DEFECTIVE BOARD, AND OUTPUT AND DISPLAY│
        │ INSPECTION RESULT AND MEASURED VALUE │
        └─────────────────────────────────────┘
                  │                        ⌐S419
                  ▼
        ┌─────────────────────────────────────┐
        │         TAKE OUT BOARD              │
        └─────────────────────────────────────┘
                  │
                  ▼                        ⌐S421    NO
              ╱────────────────────────╲
             ╱      INSPECTION IS        ╲
            ⟨  ENDED FOR BOARDS OF IDENTICAL ⟩
             ╲          KIND?           ╱
              ╲────────────────────────╱
                  │ YES
                  ▼
        ┌─────────────────────┐
        │    INSPECTION END   │
        └─────────────────────┘
```

## FIG. 5

```
        ┌─────────────────────────┐
        │     TEACHING START      │
        └─────────────────────────┘
                     │
                     ▼                        ─S501
        ┌─────────────────────────┐
        │     CARRY IN BOARD      │
        └─────────────────────────┘
                     │
                     ▼                        ─S503
        ┌─────────────────────────┐
        │  SET INSPECTION RESOLUTION │
        └─────────────────────────┘
                     │
                     ▼                        ─S505
        ┌──┬───────────────────┬──┐
        │  │ SET INSPECTION WINDOW │  │
        └──┴───────────────────┴──┘
                     │
                     ▼                        ─S507
        ┌─────────────────────────┐
        │   INPUT MASK THICKNESS  │
        └─────────────────────────┘
                     │
                     ▼                        ─S509
        ┌─────────────────────────┐
        │  SET INSPECTION STANDARD │
        └─────────────────────────┘
                     │
                     ▼                        ─S511
        ┌──┬───────────────────┬──┐
        │  │    PERFORM TEST    │  │
        └──┴───────────────────┴──┘
                     │
                     ▼                        ─S513
        ┌─────────────────────────┐
        │     TAKE OUT BOARD      │
        └─────────────────────────┘
                     │
                     ▼
        ┌─────────────────────────┐
        │      TEACHING END       │
        └─────────────────────────┘
```

## FIG. 6A

```
        ┌─────────────────────────┐
        │   INSPECTION WINDOW     │
        │        SETTING          │
        └─────────────────────────┘
                     │
                     ▼                    S601
        ┌─────────────────────────┐
        │     SET HEIGHT Z TO 0    │
        └─────────────────────────┘
                     │
                     ▼                    S603
        ┌─────────────────────────┐
        │  ACQUIRE CROSS-SECTIONAL │
        │    IMAGE OF HEIGHT Z     │
        └─────────────────────────┘
                     │
                     ▼                    S605              S609
        ┌─────────────────────────┐        ┌─────────────────┐
        │  COMPUTE VARIANCE V(Z) OF│        │   Z = Z + 1     │
        │   CROSS-SECTIONAL IMAGE  │        └─────────────────┘
        └─────────────────────────┘
                     │
                     ▼           S607    YES
              ╱ Z IS          ╲───────────────►
             ╱ LOWER THAN THE  ╲
             ╲ NUMBER OF        ╱
              ╲ CROSS-SECTIONS?╱
                     │ NO
                     ▼                    S611
        ┌─────────────────────────┐
        │    COMPUTE Z HAVING      │
        │  MAXIMUM VARIANCE V(Z)   │
        └─────────────────────────┘
                     │                    S613
                     ▼
        ┌─────────────────────────┐
        │  ACQUIRE CROSS-SECTIONAL │
        │    IMAGE OF HEIGHT Z     │
        └─────────────────────────┘
                     │                    S615
                     ▼
        ┌─────────────────────────┐
        │    PERFORM BINARIZATION  │
        └─────────────────────────┘
                     │                    S617
                     ▼
        ┌─────────────────────────┐
        │   PERFORM LABELLING OF   │
        │      SOLDER PORTION      │
        └─────────────────────────┘
                     │                    S619
                     ▼
        ┌─────────────────────────┐
        │ PERFORM LABELLING OF VISUAL
        │  FIELD USING SETTING VALUE
        └─────────────────────────┘
                     │
                     ▼
        ┌─────────────────────────┐
        │          RETURN          │
        └─────────────────────────┘
```

FIG. 6B

FIG. 7

701

## FIG. 8

```
        ┌─────────────────────────┐
        │      TEST BUTTON        │
        │  PRESSING/TEST START    │
        └─────────────────────────┘
                    │
                    ▼                          S701
        ┌─────────────────────────┐
        │ DISPLAY INSPECTION HEIGHT,│
        │ INSPECTION IMAGE, AND TEST│
        │         RESULT          │
        └─────────────────────────┘
                    │
                    ▼              S703
            ◇ INSPECTION RANGE IS ◇──NO──┐
            ◇     PROPER?         ◇       │
                    │                     ▼              S705
                   YES          ┌──────────────────────┐
                    │           │  CORRECT INPUT VALUE  │
                    │           │   OF MASK THICKNESS   │
                    │           └──────────────────────┘
                    ▼              S707
            ◇   INSPECTION        ◇──NO──┐
            ◇ SETTING ITEM AND STANDARD  │
            ◇   ARE PROPER?       ◇       │
                    │                     ▼              S709
                   YES          ┌──────────────────────┐
                    │           │ CORRECT INPUT VALUES OF│
                    │           │ INSPECTION SETTING ITEM│
                    │           │     AND STANDARD      │
                    ▼           └──────────────────────┘
        ┌─────────────────────────┐
        │        TEST END         │
        └─────────────────────────┘
```

*FIG. 9A*

*FIG. 9B*

*FIG. 10*

```
                    ┌─────────────────────┐
                    │  INSPECTION START   │
                    └─────────────────────┘
                              │
                              ▼                        ⌐S801
    ┌──────────────────────────────────────────────────┐
    │  SPECIFY THE TOTAL NUMBER OF CROSS-SECTIONAL      │
    │  IMAGES, ACQUIRE THREE-DIMENSIONAL                │
    │  RECONFIGURATION DATA OF INSPECTION TARGET        │
    └──────────────────────────────────────────────────┘
                              │
                              ▼                        ⌐S803
    ┌──────────────────────────────────────────────────┐
    │        i = 0、  Smin = MAX、  Tmin = MAX          │
    └──────────────────────────────────────────────────┘
                              │
                              ▼                        ⌐S805
    ┌──────────────────────────────────────────────────┐
    │  ACQUIRE iTH XY-CROSS-SECTIONAL IMAGE IN          │
    │  Z-DIRECTION OF INSPECTION WINDOW (XY-REGION)     │
    └──────────────────────────────────────────────────┘
                              │
                              ▼                        ⌐S807
    ┌──────────────────────────────────────────────────┐
    │         MEASURE AREA S AND ROUNDNESS T            │
    └──────────────────────────────────────────────────┘
```

## FIG. 11A

## FIG. 11B

100μm

FIG. 12

## FIG. 13A

## FIG. 13B

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2006292465 A

### Non-patent literature cited in the description

- **ROOKS S M et al.** Development of an inspection process for ball-grid-array technology using scanned-beam X-ray laminography. *IEEE transactions on components, packaging and manufacturing technology,* 01 December 1995, vol. 18, 851-860

- **BECKER S. et al.** CAD-based, high-resolution AXI of Solder joints. *OnBoard Technology,* June 2008, 14-16